(19) Europäisches Patentamt
European Patent Office
Office européen des brevets

(11) Publication number: **0 435 211 A2**

# (12) EUROPEAN PATENT APPLICATION

(21) Application number: **90125192.6**

(22) Date of filing: **21.12.90**

(51) Int. Cl.5: **C08F 20/10**, C08F 2/50, C08G 18/67, C09D 5/00, G03F 7/031

(30) Priority: **22.12.89 US 455231**

(43) Date of publication of application: **03.07.91 Bulletin 91/27**

(84) Designated Contracting States: **AT BE CH DE DK ES FR GB GR IT LI LU NL SE**

(71) Applicant: **UNION CARBIDE CHEMICALS AND PLASTICS COMPANY, INC.**
**39 Old Ridgebury Road**
**Danbury Connecticut 06817-0001(US)**

(72) Inventor: **Gerkin, Richard Michael**
**5300 Kensington Drive**
**Cross Lanes 25313, West Virginia(US)**
Inventor: **Koleske, Joseph Victor**
**1513 Brentwood Road**
**Charleston 25314, West Virginia(US)**

(74) Representative: **Wuesthoff, Franz, Dr.-Ing. et al**
**Wuesthoff & Wuesthoff Patent- und Rechtsanwälte Schweigerstrasse 2**
**W-8000 München 90(DE)**

## (54) Photo-curable, urethane-containing compositions.

(57) Photocurable composition comprising urethane compound, an ethylenically unsaturated compound, and an aromatic ketone photosensitizers with optionally additional photoinitiator that functions through a hydrogen abstraction mechanism and its use in making cured products.

EP 0 435 211 A2

# PHOTO-CURABLE, URETHANE-CONTAINING COMPOSITIONS

## BACKGROUND TO THE INVENTION

### Field of the Invention

This invention generally relates to radiation curable, urethane-containing compositions and photoinitiator compositions useful therein. More particularly, the invention relates to photopolymerizations of ethylenically unsaturated compounds using a combination of an aromatic ketone photosensitizer and a urethane compound.

### Description of the Prior Art

It is well known that photopolymerization processes have achieved considerable industrial importance particularly in situations wherein thin films or layers need to be cured in short times. Typical of such situations are the curing of clear coatings or overprint varnishes, colored coatings, inks, adhesives, printing plates, and the like. Such products are used in a variety of commercial end uses. Although the prime interest is for such thin-film technology, the importance of thick-film or thick-section, radiation-cured technology is growing and increasing in importance. Thick-section technology is important in the area of sealants, adhesives, shaped parts, printing plates, fiber glass- or carbon/graphite fiber-reinforced products, and the like.

The use of aromatic ketones such as benzophenone, benzophenone derivatives, and the like, as photosensitizers in the photopolymerization of ethylenically unsaturated compounds is also known in the art. However, some photosensitizers, such as benzophenone, will not function when used alone and require the presence of a second compound, a synergist. In addition, markedly faster polymerization rates can be obtained by the use of combinations of such aromatic ketones with synergists than is the case when such photosensitizers are used alone. The synergists usually are low molecular weight tertiary amines, ureas, and amides.

Combinations of photosensitizers and synergists that are commonly used include mixtures of one or more aromatic ketones, one of which is benzophenone, isopropylthioxanthone, or the like and a low molecular weight tertiary amine such as dimethylethanol amine, triethylamine, bis-(4,4'-dimethylamino)-benzophenone (Michler's ketone), or the like. The combination of photosensitizer and a synergist is termed a photoinitiator system or photoinitiator combination. Such combinations are said to function through an intermolecular hydrogen abstraction mechanism in which ultraviolet light is absorbed by the aromatic ketone which interacts with an amine or other suitable low molecular weight nitrogen-containing compound that has an alpha-hydrogen and rapidly forms an excited complex. This complex, or "exiplex" as it is often termed, undergoes rearrangement with the transfer of a hydrogen atom from the amine causing the amine to become the free radical initiator molecule that causes rapid polymerization of acrylates and other appropriate ethylenically unsaturated compounds. If used alone, the amine or other nitrogen-containing compound will not effect polymerization. Although this mechanism is thought to be true, this invention is not limited by it or any other described mechanism.

It is known to use low molecular weight amines in combination with aromatic or diaryl ketones to form photoinitiator systems. For example, G. F. Vesley, J. Radiation Curing, 13 (1), 4 (1986) discusses combination diaryl ketone/amine hydrogen-abstracting initiators for the radiation polymerization of acrylates. P. N. Green, Polymers Paint Colour J., 175 (4141), 246 (April 17, 1985) also discusses such compounds and points out that compounds such as benzophenone are usually used in combination with tertiary amines for the ultraviolet light curing of acrylates. Table 9 of this article lists N-methyldiethanolamine, triethanolamine, 2-(dimethylamino)ethylbenzoate, ethyl-4-dimethylaminobenzoate, and n-butoxyethyl-4-dimethylaminobenzoate as examples of coinitiator, tertiary amines that are used in the art.

The use of low molecular weight ureas in polymerization reactions activated by radiation has been described in the art. U.S. Patent No. 3,993,549 is a description of the addition of powdered urea to liquid polyene-polythiol systems that are to be cured with actinic radiation such as ultraviolet light or ionizing radiation in the presence of photosensitizers such as aromatic ketones.

U.S. Patent Nos. 4,425,208 and 4,518,473 describe methods for the photopolymerization of ethylenically unsaturated compounds wherein combinations of an aromatic ketone photosensitizer and low molecular weight tetrasubstituted ureas and disubstituted amides are employed as the photoinitiators.

U.S. Patent No. 4,446,247 describes liquid photoinitiator compositions that contain an aromatic ketone

photosensitizer and a low molecular weight tetrasubstituted urea or disubstituted amide and that are useful for the radiation activated polymerization of ethylenically unsaturated compounds.

U.S. Patent No. 4,761,435 describes the use of polyamine resins which preferentially are polytertiary amine resins in combination with aryl ketone photosensitizers such as benzophenone. It is preferred that acrylic copolymers containing copolymerized tertiary amine-functional monomers such as dimethylaminoethylacrylate be used. It is mentioned that primary amine derivatives of polyoxypropylene compounds can be used and one that is trifunctional in nature with an equivalent weight of 139 (Jeffamine T-403) is listed in a table but is not used in the ensuing examples.

Belgium Patent No. 884,395 deals with the radiation curing of acrylates in combination with low molecular weight compounds of the N-vinyl amide type. The list of suitable compounds in this reference mentions and the patent claims, but does not exemplify, the use of low molecular weight compounds such as N-vinylmethyl-N'-dimethyl urea and other tetrasubstituted, vinyl-containing ureas in combination with acrylates.

The preparation and use of urethane acrylates in radiation curing, wherein said urethane acrylates or, as they are also designated, acrylated urethanes are prepared by reacting a polyol and a polyfunctional isocyanate to make an isocyanate-terminated prepolymer that is then further reacted with an hydroxy acrylate, such as 2-hydroxyethyl acrlate, to form compounds that are end capped or terminated with acrylic functionality, is also known. Such compounds are incorporated or polymerized into radiation-curable coatings by the addition polymerization of the terminal unsaturation, i.e. through the acrylate groups, of the molecule. It is further well known that such compounds have very high viscosities and must be diluted for use in radiation cure systems.

U.S. Re. 29,131 contains a description of how a variety of such urethane acrylates or acrylated urethanes can be made from caprolactone polyols, multifunctional isocyanates, and hydroxyalkyl acrylates. Urethane compounds such as these are incorporated into ultraviolet light polymerized polymeric networks through the acrylate end groups and depend on them for utility. A paper, "Formulating Ultraviolet Curable Coatings," by E. Levine that appeared in Modern Paint and Coatings, Pages 26-29, August 1983, also describes the preparation and use of urethane acrylates in radiation curable formulations. This paper further describes the use of a benzophenone/ methyldiethanolamine mixture as the initiator system for ultraviolet light polymerization of the ethylenic unsaturation--i.e. acrylate functionality--in a formulation of an acrylated urethane and other acrylates. The article also points out the high viscosity of 500,000 cps for the acrylated urethane and the importance of using monomers to dilute the viscosity of the formulated system.

It is also known that of the various types of ethylenic unsaturation that exist, vinyl functionality is markedly less responsive to ultraviolet light initiated polymerizations than acrylic functionality with vinyl < allyl < methacrylate < acrylate existing as an order of reactivity for ultraviolet light polymerization of ethyleneically unsaturated compounds as listed by K. J. O'Hara in "Resins and Monomers for Today's Radiation Curable Coatings," Page 116 in Radiation Curing of Polymers edited by D. R. Randell and published by Whitstable Litho Ltd., Whitstable, Kent, Great Britain, (1987).

Although such combinations can give very good results in terms of rate of cure, they can have a number of disadvantages. These disadvantages include giving rise to yellowing or other discoloration of the finished polymeric film, unpleasant odors in the liquid formulation and the cured film, health hazards since Michler's ketone is carcinogenic, decreased storage stability, and emulsification in certain application methods, such as web offset printing, when aliphatic amines or alkanolamines are used. Another disadvantage of radiation cured ethylenically unsaturated compounds is poor adhesion that is caused by the large amount of shrinkage that occurs during the ethylenic unsaturation polymerization process. Decreasing the amount of ethylenic unsaturation, which is usually present in the form of acrylic functionality, in a coating, ink, or adhesive formulation is advantageous in that it will decrease shrinkage and improve adhesion.

## OBJECTIVES OF THE INVENTION

An object of the present invention is to enhance the mechanical property characteristics such as adhesion, flexibility, softness, gloss, toughness, and/or other functional or decorative properties of coatings, inks, adhesives, sealants, and fabricated parts.

Another object of the present invention is to significantly decrease the amount of ethylenically unsaturated acrylate used in a given formulation, which acrylates are known to be skin and eye irritants and which can have other undesirable health characteristics.

Yet another object of the present invention is to provide less system polymerization shrinkage and thus improved inherent adhesion in the final cured film or product.

Other objects will become apparent from the specification and examples which follow.

SUMMARY OF THE INVENTION

This invention provides the use of urethane compounds that are the reaction products of polyols and isocyanates as aromatic ketone photosensitizer synergists or cophotosensitizers in photo-curable, ethylenically-unsaturated formulations that are suitable for use as coatings, inks, adhesive, sealants, and fabricated parts.

It has now been found that the combinations of this invention give excellent rates of photopolymerization when used in systems that involve the photopolymerization of ethylenic double bonds such as those contained in acrylates without exhibiting the disadvantages described above.

Although it is preferred in the practice of this invention that the urethane-containing compositions of the invention be used with aromatic ketone photosensitizers such as benzophenone, chlorothioxanthone, and the like, that function through an intermolecular hydrogen abstraction mechanism, other photoinitiators can be used. In addition, the aromatic ketone photosensitizers can be used alone, in combination with each other, or in combination with photoinitiators that function via a homolytic fragmentation mechanism when used in combination with the urethane compounds and photopolymerizable ethylenically unsaturated compounds. The composition can contain various amounts of the urethane compounds wherein said amounts will depend on the molecular weight/equivalent weight of the urethane compound and on the desired performance requirements of the cured product.

The invention also consists of liquid photoinitiator compositions that are combinations or mixtures of urethane compounds and one or more aromatic ketone photosensitizers and which can optionally contain photoinitiators that function via an homolytic fragmentation mechanism.

DETAILED DESCRIPTION OF THE INVENTION

In accordance with the present invention there is provided urethane compounds prepared from the reaction of polyols and isocyanates which urethane compounds are of the following general formula:

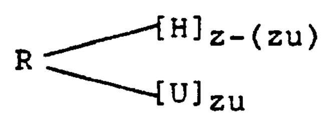

wherein R is an initiator radical based on a compound containing Zerwitinoff active hydrogen atoms and is capable of initiating polymerization with alkylene oxides when used with a suitable catalyst such as potassium hydroxide, zinc hexacyanocobaltate, and the like. It is understood by those skilled in the art that not all of the potential active hydrogen atoms must become activated during the reaction process of making polyols and some of the starting functionality such as hydroxyl may remain on the initiator molecule.

Examples of such compounds that contain Zerwitinoff active hydrogen atoms include but are not limited to difunctional compounds such as ethylene glycol, propylene glycol, water, 1,4-butanediol, diethyleneglycol; trifunctional compounds such as trimethylolpropane, glycerol, trimethylolethane; and other higher functional compounds such as pentaerythritol, sorbitol, sucrose, ammonia, ethylene diamine, 1,3-diaminopropane, 1,6-hexanediamine, isomers of phenylenediamine and toluenediamine, 4,4'-diphenylmethane diamine and its isomers, diethanolamine, ethanolamine, dimethylethanolamine, N-methylethanolamine, triethanolamine, triisopropanolamine, and propylene disulfide.

Additional examples of compounds suitable for initiating polymerization of alkylene oxides are the various oligomeric polyols known in the art. These include the poly(1,4-butylene oxide) polyethers and the hydroxyl- and amine-terminated polybutadienes. When polyols (or other oligomers) are used for initiating polymerization of the alkylene oxides, their molecular weights can range from 400 to 3000 (oligomeric to polymeric). When the conventional initiators such as described above (i.e., glycerine, water, etc.) are used, their molecular weight can range from about 18 up to about 400. Preferably R contains from two to about six carbon atoms.

Examples of R include but are not limited to initiator radicals such as the following:

(1) if R is linear and has three carbon atoms as it would have from glycerol, it would have the structure

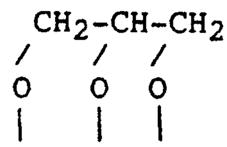 ,

(2) if R is branched and has six carbon atoms as it would have from trimethyolpropane, it would have the structure

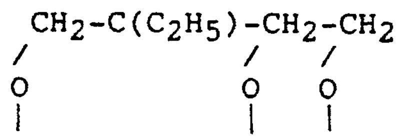 ,

and

(3) if R is branched and has 5 carbon atoms as it would have from pentaerythritol and if only three of the active hydrogens had been removed, it would have the following structure

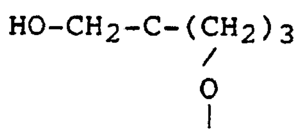 .

(4) if R is linear and difunctional and is derived from a (tetramethylene oxide)polyol or poly (1,4 butylene oxide) as it would have from the initiation and polymerization of tetrahydrofuran with water, it would have the structure

$$-[O-(CH_2)_4]_d-O-(CH_2)_4-O-$$

wherein d can range from zero to fifty with the preferred range four to 35. Hydroxyl terminated poly (tetramethylene oxide) products obtained by the polymerization of tetrahydrofuran, are commercially available as Polymeg™ and Terethane™ manufactured by Quaker Chemical Company and Dupont Company wherein the initiator is unknown.

The alkylene oxides and other monomers that find utility in the present invention are those well known in the art. These include ethylene oxide, propylene oxide, the alpha-olefin oxides such as 1,2-epoxybutane, and 1,2-epoxyoctadecane, oxetane, and tetrahydrofuran.

"H" represents a hydroxy-containing group of the formula

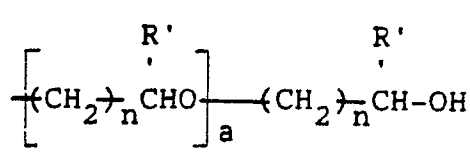

and "U" represents a urethane-containing group of the formula

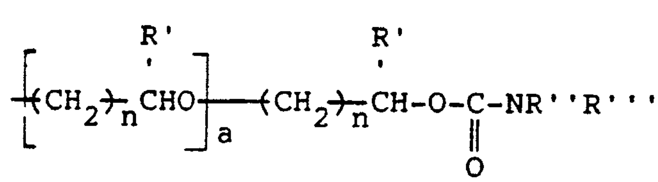

wherein:

(1) the letter "a" can range from a value of 4 to 175 with the preferred range being from 4 to 115, and,

(2) and the letter "n" equals an integer equal to from 1 to 3 and preferably 1 or 3.

Ethylene oxide, propylene oxide, alpha-olefin oxide, and tetramethylene oxide, can be incorporated into the product backbone in any sequential manner, 1.e., random or block sequence, in any configuration or conformation.

R' is hydrogen or an alkyl group containing from one up to 18 carbon atoms with it preferred that R" is hydrogen or an alkyl group with up to two carbon atoms and with it most preferred that R" is hydrogen or a methyl group.

R" and R"' are independently hydrogen or an alkyl, aryl, aralkyl, cycloalkyl, vinyl, substituted vinyl, allyl or substituted allyl group containing from one to 12 carbon atoms and preferably containing from two to six carbon atoms.

The letter "z" is an integer equal to the number of Zerwitinoff active hydrogens on the initiator and must be at least one. The letter "z" is preferably 2 to 6.

The letter "u" is the percent urethane capping of the Zerwitinoff active hydrogen atoms on the polyol, generally 0.25 to 1.0 and preferably 0.5 to 1.0.

(zu) is the product of z and u.

The above parameters describe compounds with equivalent weights ranging from about 100 to 10,000 or more when the functionality is between 2 and 6 but it is preferred that equivalent weights of from 600 to 10,000 or more be used in the practice of this invention.

Illustrative of the the isocyanates that can be used to prepare the urethane compounds of this invention (I) are phenyl isocyanate, hexyl isocyanates, butyl isocyanates, propyl isocyanates, methyl isocyanate, cyclohexyl isocyanate, benzene, 1-(1-isocyanato-1-methylethyl)-4-(1-methylethenyl)-alpha, alpha-dimethyl meta-isopropyl benzyl isocyanate (also known as m-isopropyl-alpha, alpha-dimethylbenzyl isocyanate), naphthalene isocyanate, 3-isocyanatopropyl triethoxysilane, and the like. Minor amounts of disubstituted isocyanates such as 4,4'-diphenylmethylene diisocyanate, 4,4'dicyclohexylmethylene diisocyanate, toluene diisocyanates, and the like can be used but must be limited to about 5% or less to minimize product viscosity when trifunctional or higher functionality polyols are used and less than about 50% of the total weight of isocyanate when difunctional polyols are used to prepare the urethane compound.

The urethane compounds are prepared from an appropriate polyol and monoisocyanate by techniques well known to those skilled in the art. The ratio of isocyanate equivalents to hydroxyl equivalents in the mixture of reactants can vary from less than about 0.25 to one. The chemicals may be reacted in bulk or solution. Usually the monoisocyanate will be slowly added to the polyol over a period of time that varies from about ten minutes or less (i.e., essentially all at once) to 48 hours or more at temperatures of about 10 °C to about 100 °C with the time and temperature dependent on the amounts of reactants being used, on the degree of mixing employed, on the type isocyanate used, and other parameters known to those skilled in the art of urethane chemical manufacture. Of course, the lower temperatures are used with the longer times and the higher temperatures are used with the shorter times. Exotherms are expected when the reactants are contacted and the mixing of reactants is carried out in a careful, safe manner. The exotherm is particularly important if the isocyanate is added all at one time, and exotherms of about 10 °C have been noted under such conditions. Reaction completion is determined by infrared analysis. It is preferred that the isocyanate be added all at once or in as short a time as practical--i.e., a factor dependant on batch/reactor size--at temperatures of about 25 °C to about 40 °C. After the exotherm takes place, the system is heated to about 60 °C to about 80 °C and held at temperature until an infrared analysis reveals that the reaction is complete. Reaction completion is usually reached in one or two hours. Optionally catalysts for the hydroxyl/isocyanate reaction can be used. Typical examples are also known to those skilled in the art and may be illustrated by the organometallic salts such as dibutyltin dilaurate, stannous octanoate, zinc octanoate and the like. Catalysts use levels may range from 0.001 percent to more than 0.1 percent based on the total system charged.

The aromatic ketone photosensitizers are those aromatic ketones which act as photosensitizers and in which a ketonic group is attached directly to a carbon present in an aromatic or unsaturated ring. Illustrative of such compounds are benzophenone and benzophenone derivatives, xanthen-9-one, thioxanthone, 2-chlorothioxanthone, isopropylthioxanthones, 2,3-diethylthioxanthone, sodium-4-(sulphomethyl)benzyl, (4-benzoylbenzyl)trimethylammonium chloride, sodium-4-(sulphomethyl)benzophenone, fluorenone, benzil, bis-(4,4'-dimethylamino)benzophenone, 4-chlorobenzophenone, 4-phenylbenzophenone, 4-p-tolylthiobenzophenone, 2-methylanthraquinone, dibenzosuberone, biacetyl, dodecylthioxanthenones, 9,10-anthraquinone, camphor quinones, 1,3,5-triacetylbenzene, 3-ketocoumarines, acridone, p-diacetylbenzene, 3-acetylphenanthrene, penanthrenquinone, and the like. Preferably, benzophenone or benzophenone derivatives.

Illustrative of the ethylenically unsaturated monomers suitable for use in the invention are the esters of acrylic and methacrylic acid with monohydric and polyhydric compounds, such as methyl, ethyl, propyl, butyl, pentyl, hexyl, octyl, decyl, and the like acrylates and methacrylates as well as the various isomers of these and other listed compounds, neopentyl diacrylate, esterdiol diacrylates such as 2,2-dimethyl-3-hydroxypropyl-2,2-dimethyl-3-hydroxypropionate diacrylate, trimethylolpropane triacrylate, pentaerythriol di-, tri-, and tetraacrylate, hyroxyethyl acrylate, hydroxypropyl acrylate, caprolactone acrylates, ethoxylated acrylates, propyoxylated acrylates, glycerol acrylates, triethylene glycol diacrylate, tetraethylene glycol diacrylate, ethoxyethyl acrylate, cyclohexyl acrylate, 2-phenoxyethyl acrylate, isobornyl acrylate, 1,3-butylene glycol diacrylate, 1,4-butanediol diacrylate, 1,6-hexanediol diacrylate, glycidyl acrylate, as well as the methacrylates of such compounds, and the like; styrene, divinylbenzene; N-vinylpyrrolidone, and the like. Illustrative of the oligomers or polymers which can be used in the photopolymerizable reaction formulations are poly(ethylene glycol) acrylates, caprolactone di-, tri-, and tetraacrylates, tripropylene glycol diacrylate, poly(propylene glycol) acrylates, ethoxylated or propoxylated Bisphenol A diacrylates, alkoxylated esterdiol diacrylates such as ethoxylated or propoxylated 2,2-dimethyl-3-hydroxypropyl-2,2-dimethyl-3-hydroxypropionate diacrylates, acrylates of caprolactone reacted with esterdiols, ethoxylated or propoxylated trimethylolpropane triacrylate, ethoxylated or propoxylated pentaerythriol di-, tri, or tetracrylate, unsaturated polyesters containing ethylenic unsaturation from maleic, fumaric, citraconic, and the like unsaturated dicarboxylic acids, urethane acrylates of various types, epoxy acrylates, acrylated polybutadiene, acrylated linseed oil, acrylated soyabean oil, and the like. Compounds such as those mentioned are known to those skilled in the art and many are commercially available. Preferably the acrylates are employed, such as monoacrylates, diacrylates, triacrylates and acrylates of higher functionality.

The photopolymerization process of this invention is conducted in accordance with procedures conventional in the art with the distinguishing feature being the use as the photoinitiator of a combination of an aromatic ketone photosensitizer and a urethane compound. The formulations or systems of this invention which are used in the photopolymerization processes comprise one or more photopolymerizable, ethylenically unsaturated monomers, oligomers, and polymers, one or more urethane compounds of the present invention, and one or more photosensitizer or mixture of photosensitizer and photoinitiator. The formulations may also contain a variety of additives including stabilizers such as hydroquinone or methyoxyhydroquinone which prevent premature polymerization during preparation, handling, and storage of the system, antioxidants, surfactants or other flow and leveling agents, fillers, pigments, silane or titanium coupling agents, thickeners, inert solvents, inert polymers, waxes, adhesion promotors, slip agents such as the silicone oils, powdered polytetrafluoroethylene and/or polyethylene, and the like which are known to those skilled in the art of coating formulation some of which are discussed in more detail below

The formulations are applied to appropriate substrates as thin films by a variety of processes illustrative of which are roll coating, dip coating, spray coating, brushing, flexographic, lithographic, and offset web printing processes, and the like.

The photopolymerization is carried out by exposing the film or coating to light radiation which is rich in short-wave radiation. Particularly useful is radiation of about 200 to about 450 nanometers in wavelength. Illustrative of appropriate light sources are low pressure, medium pressure, and high pressure mercury vapor lamps, xenon and other flash-type lamps, fluorescent lights, lasers, electrodeless mercury lamps, and the like. Other sources of radiant energy such as electron beams, gamma radiation, X-rays, sunlight, and so on can also be used.

Usually proper selection of the above formulation ingredients will yield systems that are easily applied. However, in certain cases it may be desirable to reduce the viscosity by adding one or more inert or nonreactive solvents to the systems in amounts of about one to about 25 weight percent for the purpose of improving flow characteristics or for altering other response characteristics. In certain cases, it may be desirable to use more than 25% of the solvent. Illustrative of such solvents are 1,1,1-trichloroethane, butanol, ethanol, ethoxyethanol, ethoxyethyl acetate, ethoxybutanol, ethoxybutanol acetate, butyl acetate, methyl isobutyl ketone, methyl ethyl ketone, methyl amyl ketone, propylene glycol methyl, propyl, and butyl ethers, dipropylene glycol alkyl ethers, and the like. In certain instances it may be desirable to add water or a mixture of water and organic solvent to the coating formulation.

It may also be desirable to thicken certain formulations such as those used for screen printing or other end use requiring special rheological responses. Illustrative of the various inert thickening agents that may be employed are fumed silicas, clays, glass spheres or other microballoons, aluminum trihydrate, polymers such as cellulose acetate butyrate, vinyl polymers, phenoxy, acrylates, and the like. The amount of such materials used in a system is dependent on the desired viscosity, thixotropy, or other flow characteristic and is known by those skilled in the art of formulating coatings, inks, and the like.

Although the components of the formulations are miscible, it may be necessary for times as long as 24 hours or more to elapse under ambient conditions to ensure that a photosensitizer such as benzophenone is well dissolved in the system and that optimum results are obtained. As is known to those skilled in the art of coating formulation such a time is dependent on may factors including formulation components, photosensitizer concentration, temperature, and the like. In special cases, it may be necessary to agitate the system during use to ensure miscibility of all components.

When carrying out the photopolymerizable process or method of the invention, the various components of the system can be brought together in any order using any conventional type of mechanical or manual blending equipment. The aromatic ketone photosensitizer or mixture of aromatic ketone photosensitizers, the urethane compound or mixtures of more than one of the urethane compounds if desired, and if desired the optional type photoinitiators can be added as separate components to the formulation or they can be preblended and added as a single component. If desired, the mixtures may also contain minor amounts of less than 1 percent to about 2 percent of known synergists such as diethanolamine, triethylamine, or the like. The latter preblending method is sometimes preferred since in many instances all the components of the system other than the photoinitiator composition may be prepared and stored prior to use and the photoinitiator composition is only added immediately before use. In addition, certain aromatic ketone compounds such as benzophenone are solids and require the passage of time to effect dissolution. Preblending will yield a liquid, easily handled and used mixture that is immediately ready for use. This method avoids any possible instability or reactivity problems which might arise if all the components of the system were mixed and then stored for extended periods before use. As known to those skilled in the art of formulating photocurable acrylate systems, the length of shelf storage is variable and depends on such factors as temperature, presence of light and particularly ultraviolet light, air space in container, and the like.

The amount in which the mixture of components is used in the photopolymerizable systems of the invention can vary over a wide range depending on the nature of the system. Generally, from about 2 to about 65 weight percent o the combination aromatic ketone photosensitizer and multifunctional urethane compound is used based on the total weight of the photocurable materials. Preferably, 2 to 50 weight percent. The proportion in which the aromatic ketone photosensitizer is blended with the urethane compounds of the invention is broad and depends on the molecular weight/equivalent weight of the compounds. In general the aromatic ketone photosensitizer is present in an amount ranging from about 0.5 to about 15 weight percent based on the total photocurable materials. More preferably from about 1 to about 10 weight percent is used. The photoinitiator composition can optionally contain up to about 75 weight percent of a homolytic fragmentation type photoinitiator based on the weight of the mixture of the aromatic ketone photosensitizer, urethane compound and homolytic photoinitiator.

As mentioned above, a particular embodiment of the invention comprises certain photoinitiator compositions which are mixtures of one or more aromatic ketone photosensitizer that is capable of participating in intermolecular hydrogen abstraction, one or more of the amine compounds, and optionally a photoinitiator of the homolytic fragmentation type. It has been found that such compositions are usually liquid in nature and can be stored for extended periods preferably in the absence of ultraviolet radiation or other light. If desired or if needed to effect solution of the combined compounds, an inert solvent such as those indicated above can be added to the mixture. The photoinitiator composition may optionally contain from zero to 75% by weight of a homolytic fragmentation type photoinitiator illustrative of which are the benzyl ketals, 2,4,6-trimethylbenzoyldiphenylphosphine oxide, acetophenone and derivatives such as 2,2-diethoxyacetophenone, 2,2-dimethoxy-2-phenylacetophenone, 2-hydroxy-2,2-dimethylacetophenone, and the like, 1-benzoylcyclohexan-1-ol, benzoin, alkyl benzoin ethers such as methyl, ethyl, isopropyl, n-butyl, isobutyl benzoin ethers, and the like. If desired, the photoinitiator compositions can contain from 1 to about 25% by weight of an inert solvent such as those described above. Particularly preferred photoinitiator compositions comprise mixtures of benzophenone and one or more amine compounds of the present invention.

The compositions of the invention can be exposed to radiation in a variety of atmospheres illustrative of which are air, nitrogen, argon and the like. It has been found that the coatings do not require an inert atmosphere for cure and either an active or oxygen-containing atmosphere such as air or an inert atmosphere such as nitrogen can be used.

The use of the compositions or the photoinitiator compositions of the invention gives excellent results in terms of adhesion to a variety of substrates, of rapidity with which cure of the photopolymerizable systems can be effected, in terms of surface finish which may be clear and glossy or matte in appearance, of absence of yellowing, of excellence of mechanical properties when applied in film form as well as low odor systems. In addition, if the photoinitiator compositions are preblended before use, they offer a marked advantage in ease of handling and use. In addition, it has been found that the photoinitiator combinations of the invention can be stored alone or in admixture with the other components of the photopolymerizable

systems for substantial periods (four months or more) without showing any signs of instability or being changed in any way in terms of their ability to cure the system on exposure to appropriate radiation.

The compositions of this invention are useful in a variety of end uses. Illustrative of these end uses are general metal coatings for steel, tin plated steel, tin-free steel, galvanized steel, phosphatized or other treated steel, aluminum, copper, tin-lead solders, as well as other metals, appliance coatings, business machine coatings, office equipment coatings, lamp and lighting fixture coatings, beverage and other can coatings, decorative coatings, overprint varnishes, inks, sealants, adhesives, coatings for electronics such as laser markable coatings, conformal coatings, photoresists, solder masks or resists, coatings for optical discs and compact discs, coatings for magnetic tape, coatings for optical fibers, coatings for glass fiber-reinforced polyester materials, coatings for glass or carbon fiber-reinforced composites prepared from unsaturated polyesters and styrene, coatings for sputtered or vapor deposited aluminum, gold or other metals, graphite or carbon fiber reinforced laminates/composites, coatings for glass, wood, plastics such as polyesters, polycarbonate, polysulfone, treated polyethylene and polypropylene, and shaped products such as those prepared using stereo lithography and the like.

Whereas the exact scope of the instant invention is set forth in the appended claims, the following specific examples illustrate certain aspects of the present invention and, more particularly, point out methods of evaluating the same. However, the examples are set forth for illustration only and are not to be construed as limitations on the present invention except as set forth in the appended claims. All parts and percentages are by weight unless otherwise specified.

The coating compositions prepared in the examples below were evaluated according to the following procedures.

Solvent Resistance (Double Acetone Rubs):

A measure of the resistance of the cured film to attack by acetone in which a film coating surface was rubbed with an acetone-soaked cloth back and forth with hand pressure. A rub back and forth over the film coating surface with the acetone soaked cheesecloth was designated as one "double acetone rub." The effect that a certain number of double acetone rubs had on the film coating surface was reported by a number in parenthesis following the number of double acetone rubs. The rating system for evaluating acetone resistance for a given number of double acetone rubs was as follows:

Number in Parenthesis After Number of Rubs
(1) No change in coating appearance
(2) Surface scratched
(3) Surface dulled or marred. some coating removed
(4) Breaks in coating apparent
(5) About 50% or more of coating removed

Pencil Hardness:

Pencil leads of increasing hardness values were forced against the film coating surface in a precisely defined manner as described in ASTM D3363-74 until one pencil lead cut through the surface of the film coating. The surface hardness was considered as the hardest pencil grade which just failed to cut or mar the film coating surface. The pencil leads in order of softest to hardest were reported as follows: 6B, 5B, 4B, 3B, 2B, B, HB, F, H, 2H, 3H, 4H, 5H, 6H, 7H, 8H, AND 9H.

Crosshatch Adhesion:

A lattice pattern with ten cuts in each direction was made in the coating film to the substrate and pressure-sensitive adhesive tape (Scotch Brand 606) was applied over the scored/cut substrate and then rapidly removed as prescribed in ASTM D3359-78. The adhesion was evaluated by comparison with descriptions and illustrations as more fully detailed in the cited method.

Gardner Impact Resistance:

A measure of the ability of a cured film coating on a substrate to resist rupture from a falling weight. A Model IG-1120 Gardner Impact Tester equipped with an eight-pound dart was used to test film coatings cast and cured on steel panels. The dart was raised to a given height in inches and dropped onto either the coated side of the coated steel panel (direct or forward impact resistance) or the uncoated side of the

coated steel panel (reverse impact resistance). The height-of-drop in inches times weight of dart (8 pounds), designated as inch-pounds, absorbed by the film without rupturing was recorded as the films direct or reverse impact resistance.

Gloss:

Gloss measurements were made at either 20 degrees and/or 60 degrees in accordance with ASTM D523-78 using a Gardner gloss meter equipped with 20 and 60 degree heads.

GLOSSARY Isocyanate I is m-isopropenyl-alpha,alpha-dimethylbenzyl isocyanate with a molecular weight of 201, a theoretical isocyanate content of 20.9%, and a boiling point of 270 °C. It is marketed by American Cyanamide Company under the tradename TMI.

Polyol I is a trifunctional propylene oxide polyol started or initiated with glycerol and with an average hydroxyl number of 28.25 and an equivalent weight of 1986. It is marketed by Union Carbide Corporation under the designation E-685.

Polyol II is a commercial trifunctional propylene oxide polyol started or initiated with glycerol and with an average hydroxyl number of 112 and equivalent weight of 500. It is marketed by Union Carbide Corporation under the designation NIAXTM Polyol LHT-112.

Polyol III is a commercial trifunctional propylene oxide polyol started or initiated with glycerol and with an average hydroxyl number of 56 and an equivalent weight of about 1000. It is marketed by Union Carbide Corporation under the designation NIAXTM Polyol LHT-56.

Polyurethane I. A polyurethane product with a total unsaturation number of 0.477 meq/g and a viscosity of 4,028 cp at 25 °C, having the following average formula:

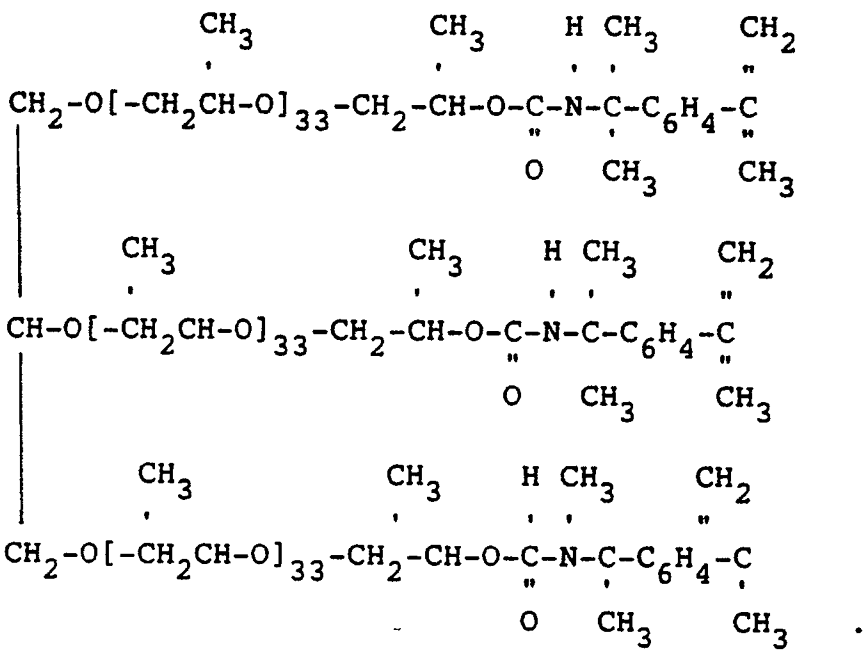

Polyurethane II. A polyurethane product that contains both urethane linkages and hydroxyl end groups. It has a total unsaturation number of 0.251 meq/g and a viscosity of 2,517 cp at 25 °C and with Formula I average parameters of R = $-OCH_2-OCH-OCH_2-$, u = 0.5, z = 3, n = 1, a = 33, R' = $-CH_3$, R'' = $-C(CH_3)_2-C_6H_4-$, and R''' = $CH_2=C-CH_3$.

TMPTA is trimethylolpropane triacrylate which is commercially available from a number of suppliers.

EXAMPLES

Example 1. Five hundred grams (0.252 equivalents) of Polyol I were placed in a four-necked, glass reaction flask equipped with a stirrer, thermowatch, thermometer, and a nitrogen inlet/outlet, purged with nitrogen, and heated to 70 °C under a nitrogen blanket. Then, 50.6 g (0.252 equivalents) of Isocyanate I

were added in a steady stream over about a ten-minute period while stirring the reaction mixture. After the isocyanate addition was complete, 100 ppm (0.055 g) of dibutyltin dilaurate were added. The system was allowed to react for 3-4 hours at temperature. Infrared analysis indicated the reaction was complete. The residue product was analyzed, designated as Polyurethane I, and stored for future use.

Example 2. Five hundred grams (0.252 equivalents) of Polyol I were placed in a four-necked, glass reaction flask equipped with a stirrer, thermowatch, thermometer, and a nitrogen inlet/outlet, purged with nitrogen, and heated to 70°C under a nitrogen blanket. Then, 25.3 g (0.126 equivalents) of Isocyanate I were added in a steady stream over about a ten-minute period while stirring the reaction mixture. After the isocyanate addition was complete, 100 ppm (0.053 g) of dibutyltin dilaurate were added. The system was allowed to react for 3 to 4 hours at temperature. Infrared analysis indicated the reaction was complete. The residue product was analyzed, designated as Polyurethane II, and stored for future use.

Control Examples A and B and Examples 3 and 4. The following ingredients were placed in glass containers and well mixed to form coating formulations. After dissolution of the benzophenone photosensitizer, they were coated onto Bonderite 37 steel panels with a No. 15 wire-wound rod and cured in an air atmosphere unless trimethylol propane triacrylate, TMPTA, was being cured alone in the controls. Since it is well known that ultraviolet light exposed formulations containing only acrylic functionality are inhibited by the oxygen present in an air curing environment, a nitrogen atmosphere was used to cure Control A and B and thus giving them a more favorable environment than used used for the other examples. Control C is a formulation that contains TMPTA and the polyol that was used to prepare Polyurethane I. The compositions of Control C and Examples 3 and 4 were cured in an air environment. The formulated systems were exposed at a distance of about 5.5 inches from a stationary, 4-inch long, 100 watt-per-inch, medium pressure mercury vapor lamp for the indicated times.

| | Example | | | | |
|---|---|---|---|---|---|
| Ingredients, g | Control A | Control B | Control C | 3 | 4 |
| Polyurethane I | ---- | ---- | ---- | 4.90 | 4.90 |
| Polyol I | ---- | ---- | 4.90 | ---- | ---- |
| TMPTA | 9.90 | 9.90 | 5.00 | 5.00 | 5.00 |
| Benzophenone | 0.10 | 0.30 | 0.10 | 0.10 | 0.30 |
| UV Exposure | | | | | |
| Time, minutes | 5 | 5 | 3 | 3 | 3 |
| Test Results | | | | | |
| Double Acetone Rubs | No Properties were | No Properties were | * | 100 (1) | 100 (1) |
| Pencil Hardness | determined | determined | <6B | H | F |
| Crosshatch Adhesion | System did not cure, become solid in time used. | System did not cure, become solid in time used. | 5B | 4B | 4B |

* System had the coating partially removed after 50 double acetone rubs and after the rubbing had ceased and the acetone had evaporated, the remaining

coating blistered and could be easily removed from the substrate by very gentle hand rubbing. After standing at room temperature for a few days, the untested coating had a greasy "bloom" which suggests unreacted polyol is exuding to the coating surface.

Control Examples A and B demonstrate that TMPTA alone remains liquid and would not cure, i.e. crosslink, during the exposure time, which was significantly longer than that used for Examples 3 and 4, when an intermolecular hydrogen abstraction-type photosensitizer, benzophenone, is used. In the presence of an alpha hydrogen source, such as a polyol or Polyurethane I, cure does take place as demonstrated with Control C and in Examples 3 and 4. However, in the case of the polyol, which is the polyol used to prepare Polyurethane I which was used in Examples 3 and 4, the polyol does not cure into the system to the degree necessary for a long lasting, durable coating as evidenced by the poor solvent resistance and the "bloom" which develops on the surface. In contrast, when Polyurethane I is used in the photocurable composition, a useful coating with excellent solvent resistance, good adhesion, and good hardness with no evidence of bloom is obtained, indicating reaction of the polyoxypropylene-urethane compound and the acrylate has taken place and a desirable coating has resulted.

Examples 5 and 6. The compositions of Examples 3 and 4 were coated onto Bonderite 37 steel panels with a No. 15 wire-wound rod and exposed to the same ultraviolet light source for the same length of time as was used for Examples 3 and 4, but in this case the cure atmosphere was nitrogen. When tested, the cured film properties were the same except for the pencil hardness of the Example 6 film which was prepared from the composition of Example 3. This film had a hardness of F in comparison to the value of H obtained in Example 3. Thus, it is apparent that either environment can be used to cure the compositions of this invention.

Examples 7-10. The following ingredients were placed in glass containers and well mixed. When the benzophenone was dissolved, the compositions were coated onto Bonderite 37 steel panels with a No. 15 wire-wound rod and exposed to the same ultraviolet light source as described in Examples 3 and 4 for three minutes in an air atmosphere.. After exposure they were tested and the following results were obtained.

| | EXAMPLE | | | |
|---|---|---|---|---|
| **Ingredients, g** | **7** | **8** | **9** | **10** |
| Polyurethane I | 1.90 | 3.90 | 5.90 | 7.90 |
| TMPTA | 8.00 | 6.00 | 4.00 | 2.00 |
| Benzophenone | 0.10 | 0.10 | 0.10 | 0.10 |
| **Test Results** | | | | |
| Double Acetone Rubs | 100 (1) | 100 (1) | 100 (1) | 100 (1) |
| Pencil Hardness | 4H | 2H | 6B | <6B |
| Crosshatch Adhesion | 4B | 4B | 5B | 5B |

These results indicate that the coating film properties such as hardness and toughness can be altered or controlled when various amounts of the Polyurethane I are used in the compositions of this invention. In all cases the systems had very good to excellent adhesion indicating that the polyurethanes are functioning as adhesion promotors as well as flexibilizers. Solvent resistance as measured by acetone double rubs was excellent for all coatings.

Examples 11. A photocurable composition was prepared by placing 4.90 g of Polyamine II, 5.0 g of TMPTA, and 0.1 g of benzophenone is a glass container and mixing well. When the benzophenone was completely dissolved, the composition was coated onto a Bonderite 37 steel panel with a No. 15 wire-wound rod and exposed to the same ultraviolet light source used in Examples 3 and 4. Cure environment was an air atmosphere, and ultraviolet light exposure time was 3 minutes. The exposed coating was tack free and had the following properties: 50 (3) acetone double rubs, 6B Pencil Hardness, and 5B crosshatch adhesion:

Example 12-18. The following ingredients are reacted in the same manner as described in Examples 1 and 2. When an infrared analysis indicates the reaction between isocyanate and polyol is complete, the reaction is terminated and the residue products are stored under the indicated designations. In all cases, 100 ppm of dibutyltin dilaurate is used as a catalyst.

| Ingredients, equivalents | Example | | | | | |
|---|---|---|---|---|---|---|
| | 12 | 13 | 14 | 15 | 16 | 17 |
| Polyol II | 1.0 | 1.0 | -- | -- | 1.0 | -- |
| Polyol III | -- | -- | 1.0 | 1.0 | -- | 1.0 |
| Phenyl Isocyanate | 1.0 | -- | -- | -- | -- | -- |
| Iso-propyl Isocyanate | -- | -- | 1.0 | -- | -- | -- |
| Butyl Isocyanate | -- | 0.5 | -- | -- | -- | -- |
| Tertiary-butyl Isocyanate | -- | -- | -- | 1.0 | -- | -- |
| Isocyanate I | -- | 0.5 | -- | -- | 1.0 | 1.0 |
| Designation | | | | | | |
| Polyurethane | III | IV | V | VI | VII | VIII |

Examples 18-23. The following ingredients are placed in glass containers and well blended. When the photosensitizer (benzophenone) and/or mixture of photosensitizer and photoinitiator (IRGACURE™ 500), which is a photosensitizer by the definitions used herein, is dissolved, the compositions are coated onto Bonderite 37 steel panels with a No. 20 wire-wound rod and exposed to a 300 watt per inch, medium pressure mercury vapor light source at a conveyor speed of 10 feet per minute. The resulting coatings are useful in various end uses.

| | Example | | | | | |
|---|---|---|---|---|---|---|
| Ingredients, g | 18 | 19 | 20 | 21 | 22 | 23 |
| Polyurethane III | 3.0 | -- | -- | -- | -- | -- |
| Polyurethane IV | -- | 2.0 | -- | -- | -- | 1.0 |
| Polyurethane V | -- | -- | 1.0 | -- | -- | -- |
| Polyurethane VI | -- | -- | -- | 2.0 | -- | -- |
| Polyurethane VII | -- | -- | -- | -- | 2.5 | -- |
| Polyurethane VIII | -- | -- | -- | -- | -- | 2.0 |
| TMPTA | 5.0 | 6.0 | 6.0 | 7.0 | 6.0 | 6.0 |
| Epoxy Diacrylate* | 2.0 | 2.0 | 3.0 | 1.0 | 1.5 | 1.0 |
| Benzophenone | 0.3 | 0.3 | 0.2 | 0.3 | -- | 0.3 |
| IRGACURE™500** | -- | -- | 0.2 | -- | 0.3 | -- |

* Epoxy Diacrylate is an acrylated epoxide marketed by SARTOMER under the designation Epoxy Diacrylate C-3000. It has a viscosity of approximately one million centipoise at 25°C.

** IRGACURE™ 500 is a 50/50 mixture of (a) benzophenone and (b) IRGACURE™ 184, 1-hydroxycyclohexylphenyl ketone, marketed by Ciba-Geigy Corporation.

Example 24. A photoinitiator composition is made by dissolving 10 parts of benzophenone in 90 parts of Polyurethane I. Three parts of this photoinitiator composition are added to seven parts of TMPTA and well blended to form a photocurable composition. The photocurable composition is coated onto the same substrate in the same manner as used in Examples 3 and 4 and exposed to a 300 watt/inch focused beam medium pressure mercury vapor ultraviolet light source at a conveyor speed of 10 feet per minute. Tack free, useful coatings result.

## Claims

1. A photocurable composition comprising
   i) an aromatic ketone photosentisizer,
   ii) a urethane compound of the formula:

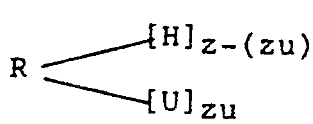

wherein
R is an initiator radical based on a compound having Zerwitinoff active hydrogen atoms and contains from two to six carbon atoms,
"H" represents a hydroxy-containing group of the formula

$$-\left[(CH_2)_n\overset{R'}{C}HO\right]_a(CH_2)_n\overset{R'}{C}H-OH$$

and "U" represents a urethane-containing group of the formula

$$-\left[(CH_2)_n\overset{R'}{C}HO\right]_a(CH_2)_n\overset{R'}{C}H-O-\underset{\overset{\|}{O}}{C}-NR''R'''$$

R' is hydrogen or an alkyl group containing from 2 to 18 carbon atoms,
R'' is hydrogen, alkyl, aryl, aralkyl, cycloalkyl, vinyl, substituted vinyl, allyl or substituted allyl group of one to twelve carbon atoms,
R''' is hydrogen, alkyl, aryl, aralkyl, cycloalkyl, vinyl, substituted vinyl, allyl or substituted allyl group of one to twelve carbon atoms,
a has a value of 4 to 175,
n has a value of 1 to 3, and
z has a value of one to six,
iii) an ethylenically unsaturated compound that will undergo photopolymerization.

2. The photocurable composition of Claim 1 wherein R contains from two to six carbon atoms, R' is hydrogen or methyl, a is from 4 to 115.

3. The photocurable composition of Claim 2 wherein a is from 4 to 90 when x is 1 or 2.

4. The photocurable composition of Claim 3 wherein a is from 4 to 25 when n is 3.

5. The photocurable composition of Claim 1 where the urethane compound has the structure:

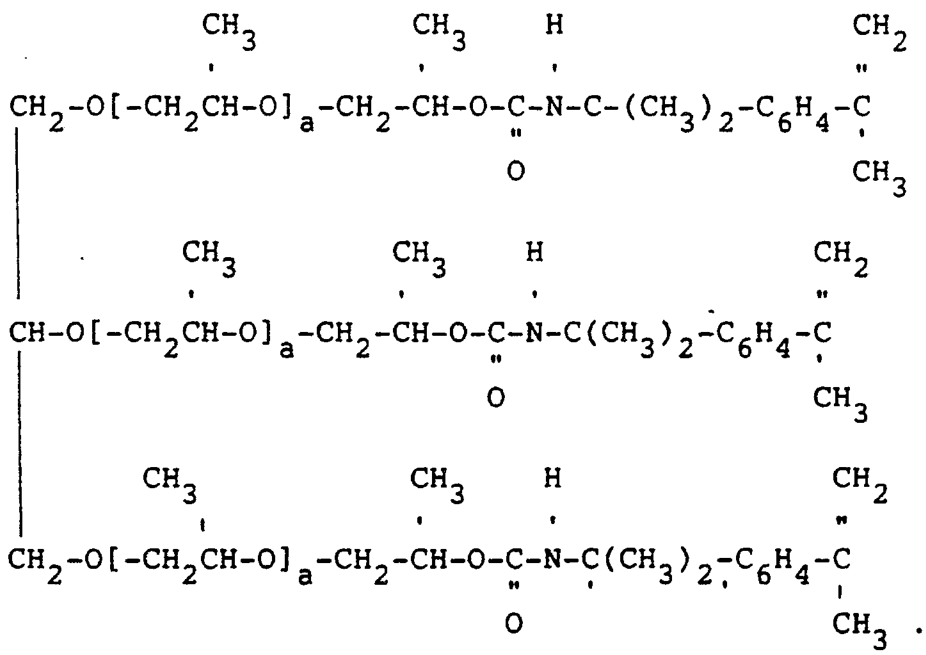

6. The photocurable composition of Claim 5 wherein a is 5 to 40.

7. The photocurable composition of Claim 6 wherein a is 30 to 40.

8. The photocurable composition of Claim 1 wherein R is $-CH_2-(CH_2)_2-CH_2-$, n is three, R' is hydrogen, u is 1.0 and z is two.

9. The photocurable composition of Claim 1 wherein the urethane compound has the structure

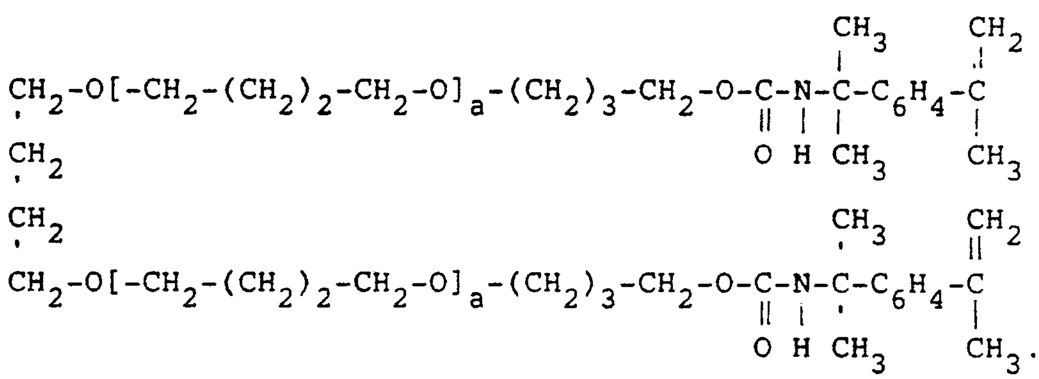

10. The photocurable composition of Claim 9 wherein a is 4 to 15.

11. The photocurable composition of Claim 1 wherein R is $-CH_2-CH_2-$, n = 1, R' is hydrogen, u is 1.0 and z is two.

12. The photocurable composition of Claim 11 wherein R' the urethane compound has the structure

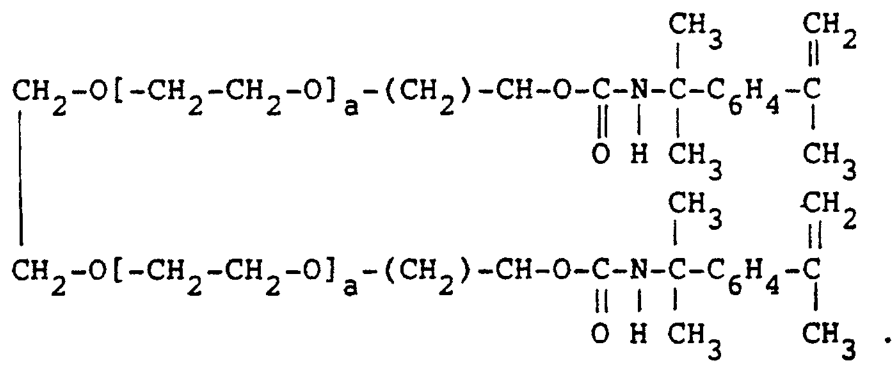

13. The photocurable composition of Claim 1 wherein the aromatic ketone photosensitizer is benzophenone.

14. The photocurable composition of Claim 1 wherein the aromatic ketone photosensitizer is a mixture of benzophenone and isopropylthioxanthone.

15. The photocurable composition of Claim 1 which also contains one or more photoinitiators of the homolytic fragmentation type.

16. The photocurable composition of Claim 15 wherein the photoinitiator is 1-hydroxycyclohexylphenyl ketone.

17. The photocurable composition of Claim 15 wherein the photoinitiator is 2,2-diethoxyacetophenone.

18. The photocurable composition of Claim 13 wherein the photocurable composition also contains 1-hydroxycyclohexylphenyl ketone as a photoinitiator.

19. The photocurable composition of Claim 1 wherein the ethylenically unsaturated compound is selected from the group consisting of monoacrylates, diacrylates, triacrylates and higher functionality acrylates.

20. The photocurable composition of Claim 19 wherein the acrylate is trimethylolpropane triacrylate.

21. The photocurable composition of Claim 19 wherein the acrylate is an urethane acrylate.

22. The photocurable composition of Claim 19 wherein the acrylate is an epoxy acrylate.

23. The photocurable composition of Claim 17 wherein the acrylate is a mixture of trimethylolpropane triacrylate and an epoxy acrylate.

24. The photocurable composition of Claim 19 wherein the acrylate is a mixture of trmethylolpropane triacrylate and an urethane acrylate.

25. A photoinitiator composition comprising
  a) from about one to 75 percent by weight of an aromatic ketone photosensitizer, and
  b) from 25 to 99 percent by weight of a urethane compound of the general formula:

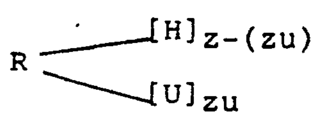

wherein

R is an initiator radical based on a compound having Zerwitinoff active hydrogen atoms and contains from two to six carbon atoms,
"H" represents a hydroxy-containing group of the formula

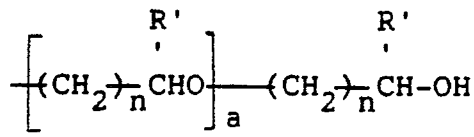

and "U" represents a urethane-containing group of the formula

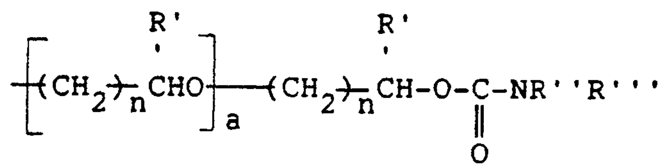

R' is hydrogen or an alkyl group containing from 2 to 18 carbon atoms,
R" is hydrogen, alkyl, aryl, aralkyl, cycloalkyl, vinyl, substituted vinyl, allyl or substituted allyl group of one to twelve carbon atoms,
R''' is hydrogen, alkyl, aryl, aralkyl, cycloalkyl, vinyl, substituted vinyl, allyl or substituted allyl group of one to twelve carbon atoms,
a has a value of 4 to 175,
n has a value of 1 to 3, and
z has a value of one to six,
iii) an ethylenically unsaturated compound that will undergo photopolymerization.

**26.** The photoinitiator composition of Claim 25 wherein R contains from two to six carbon atoms, R' is hydrogen or methyl, a is from 4 to 115.

**27.** The photoinitiator composition of Claim 26 wherein a is from 4 to 90 when x is 1 or 2.

**28.** The photoinitiator composition of Claim 27 wherein a is from 4 to 25 when n is 3.

**29.** The photoinitiator composition of Claim 25 where the urethane compound has the structure:

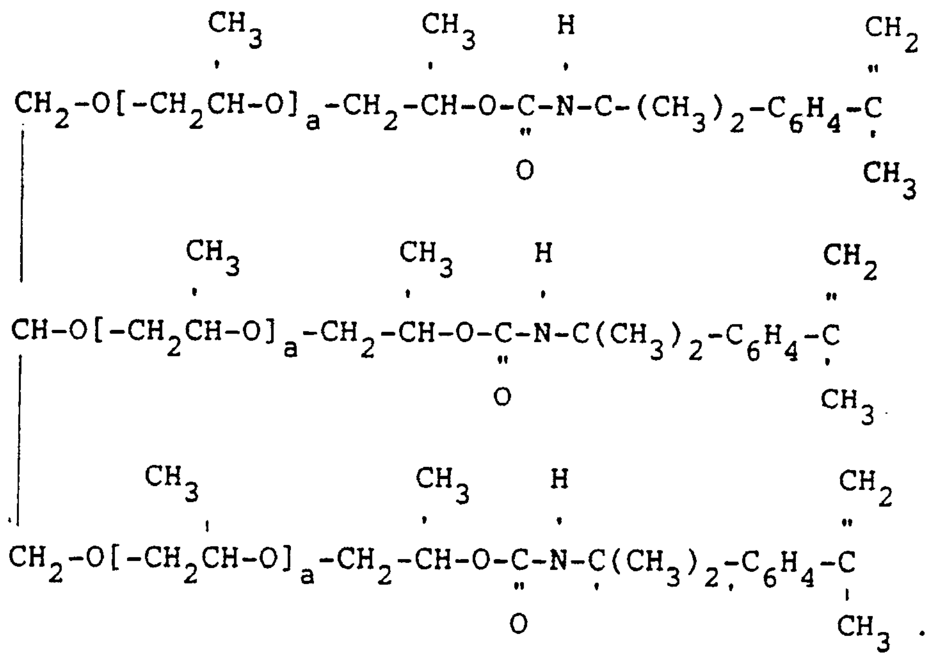

30. The photoinitiator composition of Claim 29 wherein a is 5 to 40.

31. The photoinitiator composition of Claim 30 wherein a is 30 to 40.

32. The photoinitiator composition of Claim 25 wherein R is $-CH_2-(CH_2)_2-CH_2-$, n is three, R' is hydrogen, u is 1.0 and z is two.

33. The photoinitiator composition of Claim 25 wherein the urethane compound has the structure

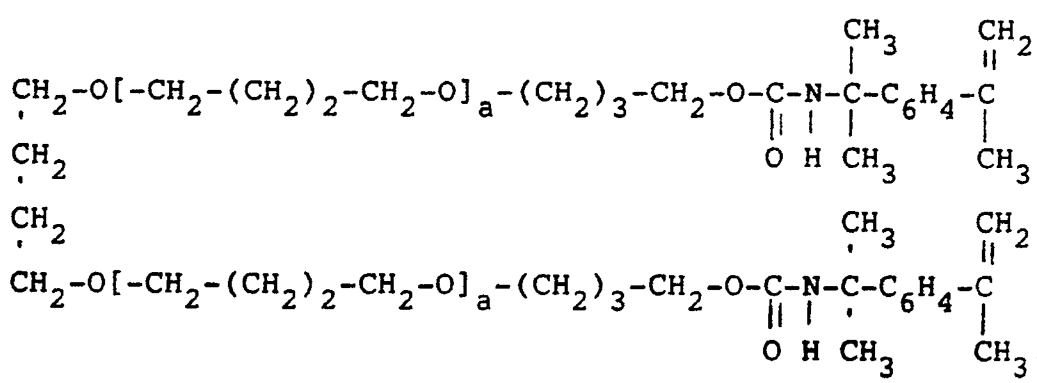

34. The photoinitiator composition of Claim 33 wherein a is 4 to 15.

35. The photoinitiator composition of Claim 25 wherein R is $-CH_2-CH_2-$, n = 1, R' is hydrogen, u is 1.0 and z is two.

36. The photoinitiator composition of Claim 35 wherein R' the urethane compound has the structure

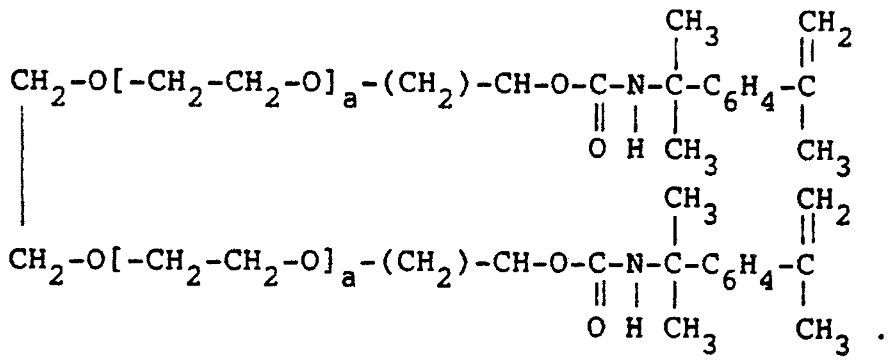

**37.** The photoinitiator composition of Claim 25 wherein the aromatic ketone photosensitizer is benzophenone.

**38.** The photoinitiator composition of Claim 25 wherein the aromatic ketone photosensitizer is a mixture of benzophenone and isopropylthioxanthone.

**39.** The photoinitiator composition of Claim 25 which also contains one or more photoinitiators of the homolytic fragmentation type.

**40.** The photoinitiator composition of Claim 39 wherein the photoinitiator is 1-hydroxycyclohexylphenyl ketone.

**41.** The photoinitiator composition of Claim 39 wherein the photoinitiator is 2,2-diethoxyacetophenone.

**42.** The photoinitiator composition of Claim 37 wherein the photocurable composition also contains 1-hydroxycyclohexylphenyl ketone as a photoinitiator.

**43.** A process for preparing a photocured product comprising:
(1) mixing until homogeneous a photocurable composition of Claim 1, and
(2) exposing the photocurable composition to ultraviolet light for a sufficient length of time to cure the composition.

**44.** The cured product of Claim 43.